# EUROPEAN PATENT APPLICATION

(11) **EP 2 740 817 A1**
(43) Date of publication of application: **11.06.2014**
(21) Application number: 12306522.9
(22) Date of filing: 05.12.2012
(51) Int. Cl.: C23C 16/24, C23C 16/509, H01L 31/18, H01L 21/02

(54) **Microcrystalline silicon thin film PECVD using hydrogen and silanes mixtures**

(71) Applicant: L'AIR LIQUIDE, SOCIETE ANONYME POUR L'ETUDE ET L'EXPLOITATION DES PROCEDES GEORGES CLAUDE, 75007 Paris (FR)
(72) Inventor: Lahootun, Vanina, 91270 VIGNEUX SUR SEINE (FR); Madec, Alain, 91140 VILLEBON S/YVETTE (FR); Amanatides, Eleftherios, 26442 PATRAS (GR); Mataras, Dimitrios, 26442 PATRAS (GR)
(74) Representative: Grout de Beaufort, François-Xavier

(57) **Abstract**

This invention describes the improvement of silicon thin film deposition, more specifically the capability to deposit microcrystalline silicon thin film which properties are suitable for a photovoltaic application in a tandem structure at increased deposition rate. This deposition is carried out under "soft" deposition conditions which are finely tuned, including mixtures of hydrogen and silanes.

## Description

The invention concerns a method of forming a microcrystalline silicon-containing film on a substrate surface by implementing a gas mixture comprising disilane, monosilane and hydrogen under soft PECVD method conditions.

Silanes, and usually monosilane - also known as silicon tetrahydride (SiH₄), are silicon precursors for deposition of amorphous silicon, polycrystalline silicon, nanocrystalline or microcrystalline silicon. Other silicon based materials such as silicon nitride can also be deposited using vapor phase based deposition processes. These deposition processes still require the same silicon precursors.

Amorphous and microcrystalline silicon based thin films deposited using monosilane are key elements in silicon thin film photovoltaic cell manufacturing. A microcrystalline phase is basically an amorphous phase containing nanocrystalline silicon grains. The deposition is performed by Chemical Vapor Deposition. Usually, it is Plasma Enhanced Chemical Vapor Deposition.

Silicon thin film deposition is a critical part of silicon thin film based photovoltaic module manufacturing. This step is carried out in Plasma Enhanced Chemical Vapor Deposition (PECVD) tools. The process requires deposition temperature in the 200°C, plasma power ranging from 220 to 600mW/cm². Pressure is kept between 65 Pa and 1333 Pa [M. Kondo, M. Fukawa, L. Guo and A. Matsuda, J. Non-Cryst. Sol. 266-269 (2000) 84, T. Roschek, T. Repmann, J. Muller, B. Rech and H. Wagner, J. Vac. Sci. Technol. A 20(2002) 492]. The silicon precursor is usually monosilane. This precursor is usually diluted in hydrogen. Some research facilities are considering the usage of argon as an alternative to hydrogen [U. K. Das, P. Chaudhuri, and S. T. Kshirsagar, J. Appl. Phys. 80, 5389 (1996)]. Depending on the doping of the silicon thin film to be deposited, doping gases such as phosphine (PH3) (for N-doped silicon thin film layers) or diborane (B2H6) / trimethylboron (TMB) (for P-doped silicon thin layers) are added to the hydrogen / monosilane mix introduced in the PECVD system. The first silicon thin film photovoltaic devices were constituted of amorphous silicon (a-Si) layers [Carlson and Wronski, Appl. Phys. Lett. 28 (1976) 671]. These devices had conversion efficiencies in the 6%. Then, the structure of the modules was more complex to improve the conversion efficiency of the whole device: a-Si /µc-Si tandem structures reached 8% [N. Wyrch et al., Proceedings 2nd World Conference on Photovoltaic Energy Conversion, Vienna, Vol. I, 467 (1998)]. To go further in the improvement of the device conversion efficiency, microcrystalline silicon (µc-Si) thin films were considered as an element of a-Si / µc-Si tandem structures. Conversion efficiency reached a maximum of 12% in the labs and 10% for industrialized modules solutions. Depending on the nature of the silicon thin film (amorphous or microcrystalline), the operating conditions of the PECVD are different. Typically, amorphous silicon thin film deposition requires moderate plasma power density, interelectrode distance in the 20 mm, temperature in the 200°C - 220°C and inlet gases composition such as 10% for monosilane and 90% for hydrogen. As for microcrystalline silicon thin film deposition, it requires higher power density, interelectrode distance in the 10 mm, temperature in the 180°C - 200°C and inlet gases composition such as 1% for monosilane and 99% for hydrogen. Improvement of conversion efficiency of devices is a significant mean to increase acceptance of the technology and ensure its deployment as long as cost continues to decrease. This cost decrease has been addressed with the evolution of the substrate size: 1,4 m² substrate is now the standard.

This capability to mass produce photovoltaic panels on larger substrates allowed significant production cost decrease. Another route to decrease manufacturing cost of these silicon thin film photovoltaic devices is to increase the throughput (to maximize the equivalent number of watt peaks) of the PECVD tools. This is explored in academic labs as well as at OEM development platforms. This throughput improvement often required to boost the silicon thin film deposition rate. Another route is of course to reduce the downtime of the equipment. As for deposition rate improvement, various paths are possible: power increase, interelectrode distance reduction, plasma frequency increase as well as pressure increase. All these means lead to increase of deposition rate. Nevertheless, such conditions are detrimental to the quality of the material. Especially for microcrystalline material, this quality is of paramount importance. High deposition rate of amorphous material is manageable. For microcrystalline material, it happens that the deposition conditions lead to a complete transition from microcrystalline to amorphous which is not suitable for the manufacturing of tandem (amorphous / microcrystalline) photovoltaic cells.

Another route to increase PECVD rate is the modification of the precursor mixture. Usually, the gases used for PECVD of silicon thin films are hydrogen and monosilane. The monosilane to hydrogen ratio ranges from below 1% to up to 20%. Depending on the nature of the silicon thin films to be deposited, the ratio must be adapted. Typically, a monosilane to hydrogen ratio below 10% is required for deposition of microcrystalline material and monosilane to hydrogen ratios of more than 5% are necessary for the deposition of amorphous material.

The usage of additives can be considered as well to boost PECVD rate. Among these additives, the usage of higher order silanes has been discussed in literature. The disilane usage and the benefit in terms of silicon thin film deposition rate are detailed in the document entitled: "PECVD of hydrogenated silicon thin films from SiH4+H2+Si2H6 mixtures" in Thin Solid Films, Volumes 451-452, 22 March 2004, Pages 255-258 (A. Hammad, E. Amanatides, D. Mataras, D. Rapakoulias). Hammad has detailed the usage of H₂ / SiH₄ / Si₂H₆ mixes and demonstrated that usage of Si₂H₆ improves significantly the deposition rate of the silicon thin films: 5% (volume) disilane added to the silicon precursor flow would improve by 200% the deposition rate of microcrystalline silicon thin film and 10% disilane addition to the monosilane silicon precursor would increase by 380% the µc-Si deposition rate. Up to now, no data has demonstrated that usage of higher order silanes can lead to microcrystalline material. As for photovoltaic applications, the deposition rate of such material is very important as it impacts the total cost of tandem photovoltaic cells.

Therefore, increasing the PECVD rate of such material and demonstrating that the quality of this material is still suitable with the expectations for a microcrystalline structure to be used for photovoltaic application would be major breakthrough.

In conclusion, usage of silanes for deposition of silicon thin films is known. Monosilane and hydrogen are usually used for industrial deposition of such thin films. Usage of higher order silanes is not common. Disilane is known to improve the deposition rate of silicon thin films. But this increased deposition rate can be inappropriate for the deposition of a microcrystalline silicon thin film, at least it is harmful to the homogeneity and structure of such film. One objective for the inventors of the present invention is to find appropriate operating conditions for deposition of such microcrystalline material.

Increase of deposition rate for silicon thin film materials is of paramount importance, especially for photovoltaic module manufacturing. As detailed above, increase of amorphous silicon thin film deposition is achievable but increase of deposition rate of microcrystalline silicon thin films often lead to transition from microcrystalline regime to amorphous regime. The usual methods based on modification of PECVD operating conditions (plasma power, plasma density, inter electrode distance a well as frequency increase) induces such phenomena or at least lead to inhomogeneous material not suitable for photovoltaic application. The inventors of the present invention have identified operating conditions not considered up to now leading to high deposition rate between 7 A/sec and 10 A/sec of homogeneous microcrystalline silicon thin films under "soft" manufacturing conditions.

The invention concerns a method of forming a microcrystalline silicon-containing film on a substrate surface, the method comprising at least the steps of:
- a first step of setting a substrate in a chamber having high-frequency electrodes for receiving a high-frequency power, the inter electrodes distance is comprised between 10 mm and 50 mm;
- a second step of supplying a reaction gas comprising a silane-type gas and hydrogen gas into said chamber, including:
   - adjusting an internal pressure of said chamber to a predetermined pressure comprised between 200 Pa and 667 Pa, preferably is equal to 400 Pa,
   - supplying a high-frequency comprised between 13,56 MHz and 70 MHz, between said substrate and said high-frequency electrodes, and
   - supplying the reaction gas to said chamber after an electric discharge occurs upon supply of the high-frequency power;
- a third step of applying a high-frequency plasma power having a discharge power density of 100 to 200 mW/cm² to said high-frequency electrodes to generate a plasma in said chamber.

### According to another embodiments, the present invention concerns:

A method as defined above, wherein said method is a PECVD method.

A method as defined above, wherein the first step includes a substep of heating said substrate to a temperature range of about 180°C to 250°C.

A method as defined above, wherein the first step includes a first substep of preheating said substrate before said substrate is set in said chamber, and a second substep of maintaining a temperature of said substrate set in said chamber in a range of about 180°C to 250°C.

A Method as defined above, wherein the second step includes a first substep of supplying a carrier gas into said chamber. A carrier gas is for example, Hydrogen, Argon or any inert gas.

A Method as defined above, wherein the reaction gas comprises SiH₄, optionally Si₂H₆ and Hydrogen.

A method as defined above, wherein monosilane to hydrogen volume ratio is comprised between 0,5% and 20%. Preferably it is comprised between 0,5% and 2,5%.

A method as defined above, wherein disilane to monosilane volume ratio is comprised between 0 and 50%. Preferably it is comprised between 5% and 30%. More preferably it is comprised between 7% and 15%. And more preferably it is equal to 10%.

A method as defined above, wherein said high-frequency supplied between said substrate and said high-frequency electrodes is equal to 27,12 MHz.

A method as defined above, wherein the inter electrode distance is 25 mm.

A method as defined above, wherein said plasma power applied in the third step is 160 mW/cm².

A method of manufacturing a semiconductor device product comprising the method as defined above wherein the substrate is a semiconductor device substrate.

A method of manufacturing a photovoltaic device product comprising the method as defined above wherein the substrate is a photovoltaic device substrate.

Astonishingly, and according to another embodiment of the invention, the following operating conditions: Plasma frequency: 27,12 MHz; Inter electrode distance: 25.10⁻³ m; Plasma power:160 mW/cm²; Plasma pressure: 200 Pa to 667 Pa; Monosilane to hydrogen volume ratio of 0,5% to 2.5%; Disilane to monosilane flowrate ratio ranging from 0% to 50%; and Total gas flow rate: 150 sccm; are compatible with high PECVD rate of silicon thin films showing microcrystalline property. These operations were not reported in literature up to now as they are not straight forward for improvement of deposition rate of silicon thin films, and especially not for microcrystalline material deposition.

This invention describes the improvement of silicon thin film deposition, more specifically the capability to deposit microcrystalline silicon thin film which properties are suitable for a photovoltaic application in a tandem structure at increased deposition rate. This deposition is carried out under "soft" deposition conditions which are finely tuned, including mixtures of hydrogen and silanes.

The invention consists in operating the PECVD in a mode that is different from the common recipes used for increase of silicon thin film deposition rate.

In fact these usual recipes suitable for enhancement of deposition rate are often detrimental to the quality of the deposited material. More specifically it is difficult to maintain the microcrystalline nature of the material under high deposition rate conditions. High deposition rate means a deposition rate superior to 5 A/sec. High deposition rate conditions are often achieved due to high plasma power (superior to 250 mW/cm²), high plasma pressure (superior to 1000 Pa) and narrow inter electrode gap (inferior to 15 mm).

Said "soft" deposition conditions are defined by plasma power inferior to 250 mW/cm², plasma pressure inferior to 1000 Pa and narrow inter electrode gap superior to 15 mm. In the present invention:
- Instead of narrowing the band gap, it is increased.
- Plasma power is kept at reasonable value whereas it is usually increased to raise plasma power density.
- Plasma pressure is kept as well at a value around 400 Pa whereas again once tends to increase the value of this operating parameter to boost deposition rate even though it may lead to harsh PECVD conditions detrimental to the properties of microcrystalline material, homogeneity and powder formation for example.
- Disilane is added to the mixture and its flow rate can be as high as 50% of the monosilane flow rate.

All depositions are performed on silicon wafers or glass substrates. All deposits are characterized in terms of Raman spectra to obtain information about the crystallinity of the material. Optical transmission spectroscopy also provides preliminary information about material refractive index, absorption coefficient as well as band gap.

The foregoing and other objects, features, aspects and advantages of the present invention will become more apparent from the following detailed description of the present invention when taken in conjunction with the accompanying examples and drawings.

### Examples:

All silicon thin film deposition tests were carried out using a PECVD set up run at a 27,12 MHz RF plasma frequency. But good results are also achieved at traditional RF plasma frequency of 13,56 MHz and 40,68 MHz, as well as higher plasma frequencies.

### 1) PECVD of a silicon thin film with no disilane under various operating conditions:

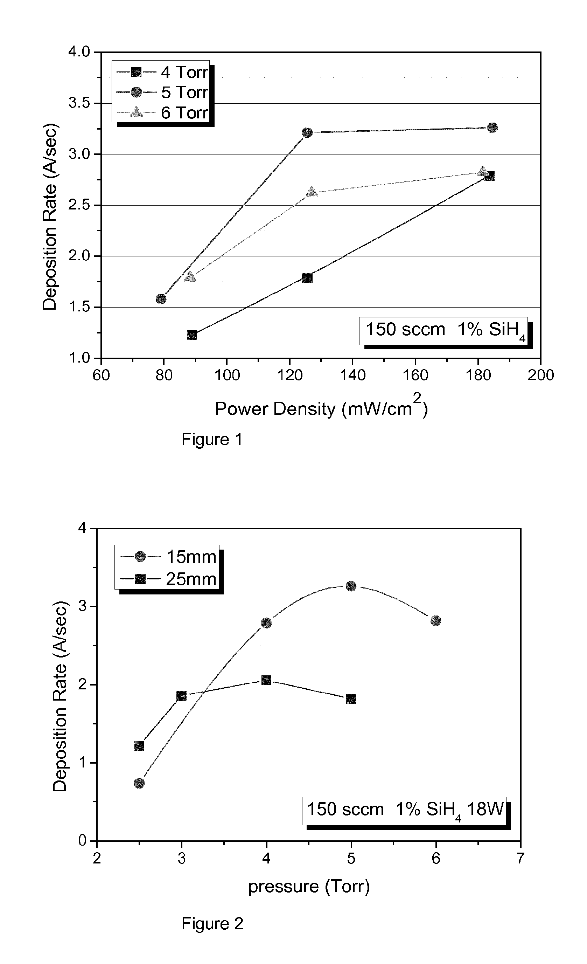

Figure 1 represents the deposition rate of silicon thin film depending on plasma power density. Various plasma pressures are explored.
Plasma power density positively impacts deposition rate of silicon thin films. This is observed at various plasma pressures (4 Torr = 533 Pa, 5 Torr =667 Pa and 6 Torr = 800 Pa). The initial deposition rates reported at 80 to 90 mW/cm² range from 1,25 to 1,75 A.s⁻¹. For a plasma power density of 180 mW/cm², deposition rates range from 2,75 to 3,25 A.s⁻¹. Respectively at 4, 5 and 6 Torr, this is a deposition rate relative improvement of 124 %, 103% and 56 %, which means that the maximum benefit of plasma power density increase is observed at the lowest operating plasma pressure. Even though there is a compromise to identify, increase of silicon thin film, based on the present results, seems achievable with increase of plasma pressure and increase of plasma power density.

Figure 2 represents the deposition rate of silicon thin film depending on plasma pressure. Inter electrode distances are explored.
Plasma pressure impacts the deposition rate of silicon thin films. This is observed at inter electrode distances of 15 mm and 25 mm. At higher plasma pressures (over 3 Torr), a 15 mm inter electrode distance provides the highest deposition rates of silicon thin films. At pressures of 3 Torr and lower, a 25 mm electrode distance seems more appropriate to generate higher silicon thin film PECVD rates. Usually, to increase deposition rate of silicon thin films, once tends to narrow the inter electrode distance.

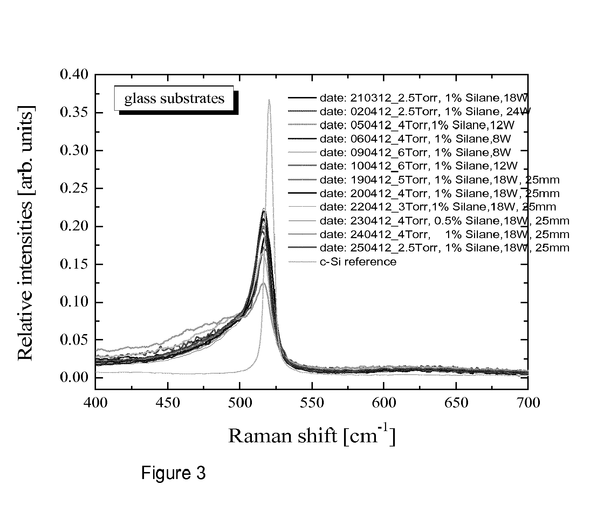

The deposits are characterized to assess the properties of the material. Raman analysis is carried out for glass substrates. Figure 3 is a Raman spectrum of various silicon thin films depending on PECVD operating conditions (no disilane). Depositions are carried out on glass substrates.

From the deconvolution of Raman spectra, once conclude that the materials have a high crystallinity. There is no impact of substrate nature on the crystallinity of the silicon thin film deposited at least at the mild conditions presented here.

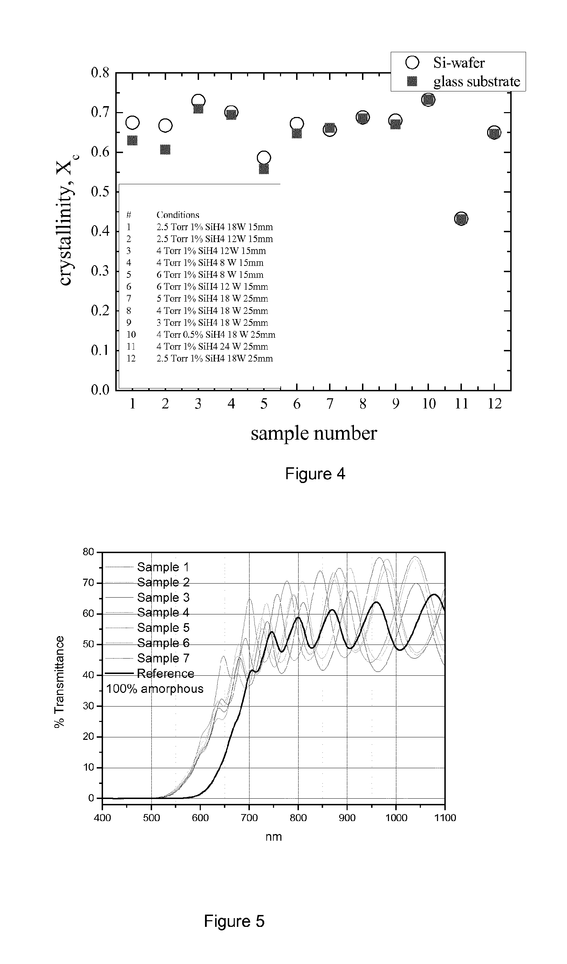

Figure 4 represents the crystallinity of various silicon thin films depending on PECVD operating conditions (no disilane). Depositions are carried out on silicon wafers or glass substrates.

From data of Figure 4, optical transmission spectroscopies were carried out to evaluate material refractive index, absorption coefficient and band gap (see Figure 5). An 100% a-Si:H film is used as reference to underline the difference with a microcrystalline silicon material: the difference in band gap edge between a-Si and µc-Si results in a much higher transmittance for µc-Si compared to a-Si for wavelengths smaller than 600 nm. Figure 5 represents transmission data of various silicon thin films depending on PECVD operating conditions (no disilane).

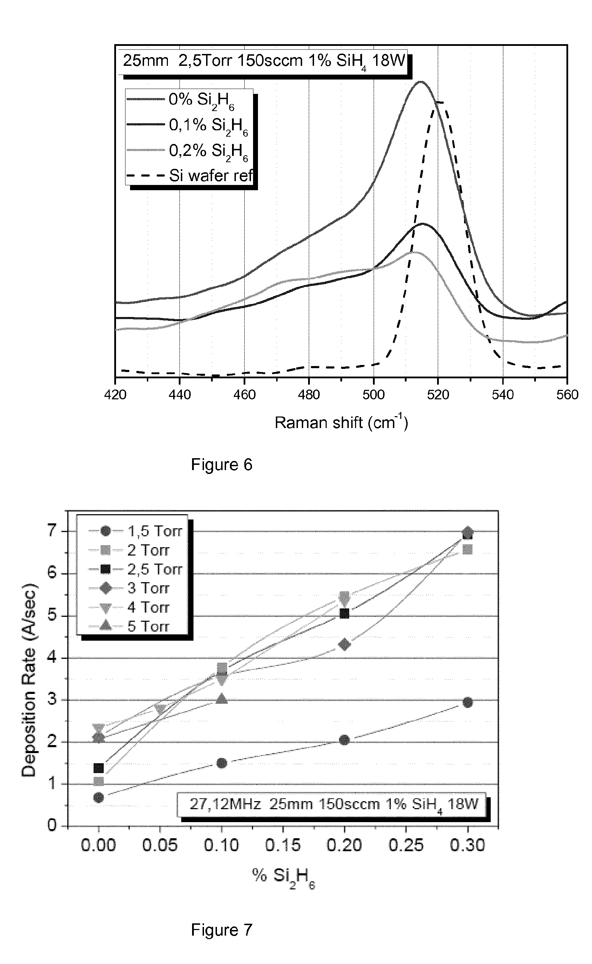

Addition of disilane impacts the properties of the material as shown on Figure 6, where there is a collapse of the crystallinity of the silicon thin films deposited under various operating conditions. This demonstrates that PECVD operating conditions must be finely tuned to ensure high deposition rate of microcrystalline silicon thin films suitable with photovoltaic applications. Figure 6 represents a Raman spectroscopy of various silicon thin films depending on disilane percentage in the gas mixture. Other PECVD operating parameters kept constant.

### 2) PECVD of a silicon thin film using disilane under various operating conditions:

Figure 7 represents the deposition rate of silicon thin film depending on disilane to hydrogen ratio in a hydrogen / monosilane mixture. Various plasma pressures are explored.

Figure 7 details the impact of disilane to hydrogen ratio in a hydrogen /monosilane mixture on deposition rate of silicon thin film. This disilane to hydrogen ratio corresponds to an increase in silicon atom feed of 0 (0.00 % Si₂H₆) to +60 % (0.30 % Si₂H₆). This work has been carried out at various plasma pressures. Depending on operating plasma pressure, deposition rate of silicon thin film ranges from 0,7 A.s⁻¹ up to 2,35 A.s⁻¹ for 0% Si₂H₆ in the gas feed. It ranges from 2,95 to more than 7 A.s⁻¹ for 0.30 % Si₂H₆ in the feed. For a given plasma pressure, the benefit in deposition rate of silicon thin film is obvious and this is detailed in Table 1.

Another interesting data is the benefit of increasing plasma density. At 0% Si₂H₆ in the feed, deposition rate can be increased from 0,7 to 2,3 A.s⁻¹, corresponding to a +228% benefit, if plasma pressure is increased from 133 Pa to 667 pa.

Table 2 shows that the maximum benefit of disilane addition is observed at specific operating conditions unusual when the aim is to increase the deposition rate in a conventional way. In fact, this maximum benefit is observed for an operating pressure of about 300 Pa. The data detailed in Table 2.

Table 2 shows a maximum benefit of disilane addition for a disilane to hydrogen ratio of 1/1000 (0,1% Si₂H₆ in the feed): deposition rate is increased by 245% compared to no disilane addition and reaches a value of 3,8 A.s⁻¹. For a disilane to hydrogen ratio of 3/1000 (0,3 % Si₂H₆), corresponding to 60 % more silicon atoms compared to the pure monosilane reference conditions, the increase in deposition rate is 500% and the deposition rate value reaches 6,6 A.s⁻¹, almost the highest deposition rate (observed in data reported in Table 4). These data provide relevant information about the compromise on pressure and disilane to hydrogen ratio to observe the maximum benefit of disilane addition.

**Table 1**

| | | | | |
|---|---|---|---|---|
| % Si₂H₆ in H₂[x] | 0 | 0,1 | 0,2 | 0,3 |
| % Si atom. [x/xo] | 0 | 20 | 40 | 60 |
| Dep. rate (A.s⁻¹) [DR] | 0,7 | 1,5 | 2 | 2,95 |
| % dep. rate [DR/DR₀] | - | 114 | 186 | 321 |
| **[DR/DR₀] / [x/x₀]** | - | **5,7** | **4,7** | **5,4** |

Table 1: Increase of deposition rate of silicon thin film resulting on addition of disilane for an operating plasma pressure of 200 Pa. All other plasma operating conditions are kept constant (plasma frequency 27,12 MHz, inter electrode distance of 25 mm, plasma power of 18 W, total gas flow rate of 150 sccm, monosilane to hydrogen ratio of 1 %)

**Table 2**

| | | | | |
|---|---|---|---|---|
| % Si₂H₆ in H₂ [x] | 0 | 0,1 | 0,2 | 0,3 |
| % Si atom. [x/xo] | 0 | 20 | 40 | 60 |
| Dep. rate (A.s⁻¹) [DR] | 1.1 | 3,8 | 5,4 | 6,6 |
| % dep. rate [DR/DR₀] | - | 245 | 390 | 500 |
| **[DR/DR₀] / [x/x₀]** | - | **12,3** | **9,8** | **8,3** |

Table 2: Increase of deposition rate of silicon thin film resulting on addition of disilane for an operating plasma pressure of 267 Pa. All other plasma operating conditions are kept constant (plasma frequency 27,12 MHz, inter electrode distance of 25 mm, plasma power of 18 W, total gas flow rate of 150 sccm, monosilane to hydrogen ratio of 1 %).

**Table 3**

| | | | | |
|---|---|---|---|---|
| % Si₂H₆ in H₂ [x] | 0 | 0,1 | 0,2 | 0,3 |
| % Si atom. [x/xo] | 0 | 20 | 40 | 60 |
| Dep. rate (As⁻¹) [DR] | 1.4 | 3,7 | 5,1 | 6,9 |
| % dep. rate [DR/DR₀] | - | 164 | 264 | 393 |
| **[DR/D_{R}] / [x/x₀]** | **-** | **8,2** | **6,6** | **6,6** |

Table 3: Increase of deposition rate of silicon thin film resulting on addition of disilane for an operating plasma pressure of 333 Pa. All other plasma operating conditions are kept constant (plasma frequency 27,12 MHz, inter electrode distance of 25 mm, plasma power of 18 W, total gas flow rate of 150 sccm, monosilane to hydrogen ratio of 1 %).

**Table 4**

| | | | | |
|---|---|---|---|---|
| % Si₂H₆ in H₂ [x] | 0 | 0,1 | 0,2 | 0,3 |
| % Si atom. [x/xo] | 0 | 20 | 40 | 60 |
| Dep. rate (A.s⁻¹) [DR] | 2,1 | 3,6 | 4,3 | 7 |
| % dep. rate [DR/DR₀] | - | 71 | 105 | 233 |
| **[DR/DR₀] / [x/x₀]** | **-** | **3,6** | **2,6** | **3,9** |

Table 4: Increase of deposition rate of silicon thin film resulting on addition of disilane for an operating plasma pressure of 400 Pa. All other plasma operating conditions are kept constant (plasma frequency 27,12 MHz, inter electrode distance of 25 mm, plasma power of 18 W, total gas flow rate of 150 sccm, monosilane to hydrogen ratio of 1 %).

**Table 5**

| | | | | |
|---|---|---|---|---|
| % Si₂H₆ in H₂ [x] | 0 | 0,1 | 0,2 | 0,3 |
| % Si atom. [x/xo] | 0 | 20 | 40 | 60 |
| Dep. rate (A.s⁻¹) [DR] | 2,3 | 3,5 | 5,4 | - |
| % dep. rate [DR/DR₀] | - | 52 | 135 | - |
| **[DR/DR₀] / [x/x₀]** | - | **2,6** | **3,4** | - |

Table 5: Increase of deposition rate of silicon thin film resulting on addition of disilane for an operating plasma pressure of 533 Pa. All other plasma operating conditions are kept constant (plasma frequency 27,12 MHz, inter electrode distance of 25 mm, plasma power of 18 W, total gas flow rate of 150 sccm, monosilane to hydrogen ratio of 1 %).

**Table 6**

| | | | | |
|---|---|---|---|---|
| % Si₂H₆ in H₂ [x] | 0 | 0,1 | 0,2 | 0,3 |
| % Si atom. [x/xo] | 0 | 20 | 40 | 60 |
| Dep. rate (A.s⁻¹) [DR] | 2,1 | 3 | - | - |
| % dep. rate [DR/DR₀] | - | 43 | - | - |
| **[DR/DR₀] / [x/x₀]** | - | **2,2** | - | - |

Table 6: Increase of deposition rate of silicon thin film resulting on addition of disilane for an operating plasma pressure of 667 Pa. All other plasma operating conditions are kept constant (plasma frequency 27,12 MHz, inter electrode distance of 25 mm, plasma power of 18 W, total gas flow rate of 150 sccm, monosilane to hydrogen ratio of 1 %).

The characterization of the materials deposited is very important to demonstrate that these "soft" operating conditions lead to the deposition of microcrystalline material.

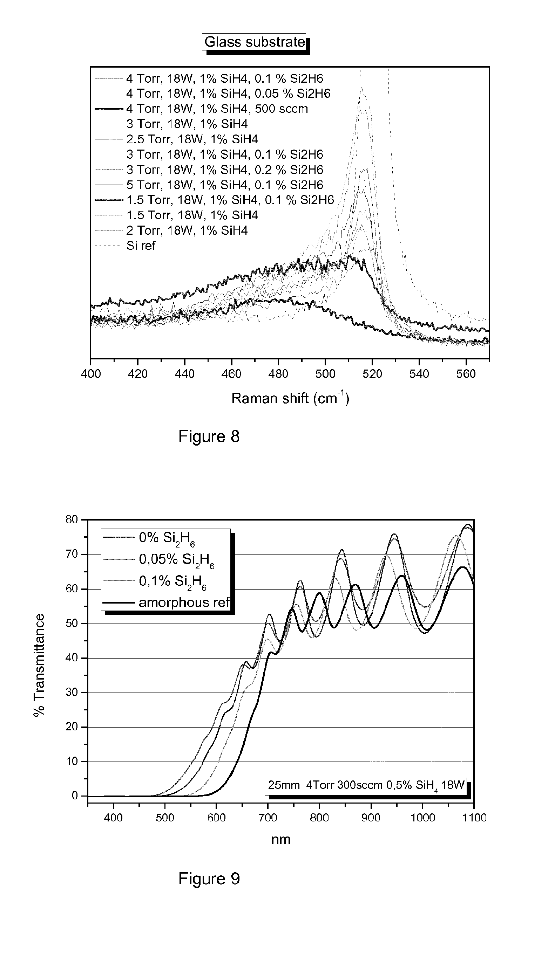

Figure 8 is a Raman spectroscopy of various silicon thin films depending on disilane percentage in the gas mixture. Other PECVD operating parameters kept constant.

Figure 9 represents Transmission spectra of various silicon thin films with no and small disilane addition at total pressure of 533 Pa.

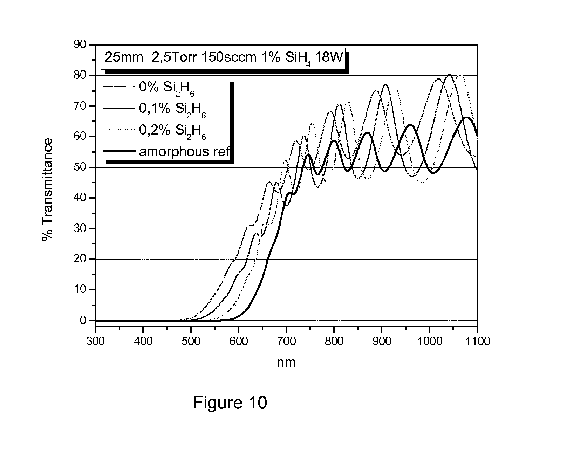

Figure 10 representsTransmission spectra of various silicon thin films with no and small disilane addition at total pressure of 333 Pa.

These last three figures show that the thin films obtained according to the method of the present invention are not amorphous but microcrystalline.

In conclusion, contrary to what is commonly believed, "soft" operating conditions can lead to increased deposition rate and good quality microcrystalline material suitable for photovoltaic applications. To ensure higher plasma enhanced chemical vapor deposition rate, disilane is used in appropriate quantities to boost plasma dissociation and subsequent material deposition in place of increase of plasma power density, plasma RF frequency, plasma pressure as well as inter electrode gap reduction and other standard means.

## Claims

1. Method of forming a microcrystalline silicon-containing film on a substrate surface, the method comprising at least the steps of:
• a first step of setting a substrate in a chamber having high-frequency electrodes for receiving a high-frequency power, the inter electrodes distance is comprised between 10 mm and 50 mm;
• a second step of supplying a reaction gas comprising a silane-type gas and hydrogen gas into said chamber, including:
- adjusting an internal pressure of said chamber to a predetermined pressure comprised between 200 Pa and 667 Pa, preferably is equal to 400 Pa,
- supplying a high-frequency comprised between 13,56 MHz and 70 MHz, between said substrate and said high-frequency electrodes, and
- supplying the reaction gas to said chamber after an electric discharge occurs upon supply of the high-frequency power;
• a third step of applying a high-frequency plasma power having a discharge power density of 100 to 200 mW/cm² to said high-frequency electrodes to generate a plasma in said chamber.

2. A method according to claim 1, wherein said method is a PECVD method.

3. A method according to claim 1 or 2, wherein the first step includes a substep of heating said substrate to a temperature range of about 180°C to 250°C.

4. A method according to claim 1 or 2, wherein the first step includes a first substep of preheating said substrate before said substrate is set in said chamber, and a second substep of maintaining a temperature of said substrate set in said chamber in a range of about 180°C to 250°C.

5. A method according to any one of the preceding claims, wherein the second step includes a first substep of supplying a carrier gas into said chamber.

6. A method according to any one of the preceding claims, wherein the reaction gas comprises SiH₄, optionally Si₂H₆ and Hydrogen.

7. A method according to claim 6, wherein monosilane to hydrogen volume ratio is comprised between 0,5% and 20%, preferably between 0,5% and 2,5%.

8. A method according to claim 6 or 7, wherein disilane to monosilane volume ratio is comprised between 0% and 50%, preferably between 5% and 30%, more preferably between 7% and 15% and more preferably is equal to 10%.

9. A method according to any one of the preceding claims, wherein said high-frequency supplied between said substrate and said high-frequency electrodes is equal to 27,12 MHz.

10. A method according to any one of the preceding claims, wherein the inter electrode distance is 25 mm.

11. A method according to any one of the preceding claims, wherein said plasma power applied in the third step is 160 mW/cm².

12. Method of manufacturing a semiconductor device product, comprising the method according to any one of claims 1 to 11 wherein the substrate is a semiconductor device substrate.

13. Method of manufacturing a photovoltaic device product, comprising the method according to any one of claims 1 to 11, wherein the substrate is a photovoltaic device substrate.
